Europäisches Patentamt

European Patent Office

Office européen des brevets

(19)

(11) Publication number: **0 030 150**
**B1**

## EUROPEAN PATENT SPECIFICATION

(12)

(45) Date of publication of patent specification: **21.03.84**  (51) Int. Cl.³: **G 11 C 19/08**

(21) Application number: **80304308.2**

(22) Date of filing: **01.12.80**

(54) **Ion-implanted bubble memory with replicate port.**

(30) Priority: **03.12.79 US 99536**

(43) Date of publication of application:
**10.06.81 Bulletin 81/23**

(45) Publication of the grant of the patent:
**21.03.84 Bulletin 84/12**

(84) Designated Contracting States:
**BE DE FR GB IT NL SE**

(56) References cited:
**US - A - 4 086 572**

**IBM TECHNICAL DISCLOSURE BULLETIN, vol.
18, no. 11, April 1976, NEW YORK (US)
HANNON & HU: "Controlled State Bubble
Splitter", page 3802**

(73) Proprietor: **Western Electric Company,
Incorporated
222 Broadway
New York, NY 10038 (US)**

(72) Inventor: **Nelson, Terence John
167 Maple Street
New Providence New Jersey 07974 (US)**

(74) Representative: **Weitzel, David Stanley et al,
Western Electric Company Limited 5, Mornington
Road
Woodford Green Essex IG8 0TU (GB)**

Courier Press, Leamington Spa, England.

Ion-implanted bubble memory with replicate port

Field of the invention

This invention relates to magnetic bubble memories and more particularly to such memories including replicate ports.

Background of the invention

A typical magnetic bubble memory is organized in a major-minor mode as first disclosed in US—A—3,618,054, of P. I. Bonyhard, U. F. Gianola and A. J. Perneski issued Nov. 2, 1971. Such a memory includes a plurality of closed loop paths, called minor loops, in which bubble patterns move synchronously in response to a magnetic field reorienting in the plane of bubble movement.

Data is read out of the minor loops and written into the minor loops by means of a major path for bubbles to which a bubble generator and a bubble detector are coupled. The major path is coupled to all the minor loops at reference positions where the minor loop ends and associated stages of the major path come into close proximity. An electrical conductor couples those positions in a manner to transfer or replicate a bubble pattern from the minor loops to within the major path.

Commercially available magnetic bubble memories have major and minor paths defined by permalloy elements of the type disclosed in US—A—4,014,009 of P. I. Bonyhard, Y. S. Chen and J. L. Smith issued March 22, 1977. Such memories in which the paths are defined by ion-implantation are disclosed in US—A—3,792,452, of M. Dixon, R. A. Moline, J. L. Horth, L. J. Varnerin, and R. Wolfe, issued Feb. 12, 1974. It is to magnetic bubble memories of the. ion-implanted type that this invention is directed, the specific problem being that a replicate port for major-minor, ion-implanted bubble memories does not exist.

There is a good reason why replicate ports in such ion-implanted memories have eluded bubble circuit designers. Ion-implanted elements for moving magnetic bubbles in response to a reorienting magnetic in-plane field are characterized by charged walls which extend outwardly from the elements and thus cause bubble elongation also outwardly from the elements. Bubble replication, in permalloy circuits, is performed by elongating the bubble, positioning it astride, for example, a portion of a conductor element, and pulsing the current element to generate a collapsing field for splitting apart the bubble, thus replicating it. Unless the bubble extends across the conductor element, no such replication is possible. Unless each end of the elongated bubble terminates or is anchored on a strong attractive pole, bubble oscillation rather than replication occurs. In permalloy devices, such elongation and anchoring occurs in response to the rotating magnetic field.

With ion-implanted circuits, no anchoring of an elongated bubble by means of a rotating magnetic field appears possible. The reason for this is that one end of a charge wall i.e., the magnetic pole generated by the rotating field, extends like a spike outwardly from the propagation elements to occupy varying (rather than fixed) positions. Further, the end of the spike coupled to the propagation elements is mobile. Consequently, the positioning of a replicate conductor astride a bubble elongated by such variable charge walls has not led to successful replication. US—A—4086572 proposes a replicator in an ion implanted circuit in which the bubble is elongated by lowering the magnetic field with a current loop. There remains, however, the problem of splitting the bubble.

Brief description of the invention

In operation of the claimed invention, in ion-implanted bubble memories, a bubble is elongated and anchored by means of a current pulse, and then split in response to the reorienting field.

In one embodiment of the invention, an ion-implanted memory device comprises a memory loop having first and second legs. A replicate conductor overlies both legs and is in alignment with a first location on each of said legs at which an attractive pole for bubbles is simultaneously periodically generated by the rotating field. During an interval when such attractive poles are present, a current pulse is applied to the replicate conductor to generate a stable field which is effective to elongate a bubble disposed on one of the legs and to stretch it between the two first locations of the memory loop legs. The elongated bubble is thereafter split by a bubble collapsing field generated by the rotating field.

Brief description of the drawing

Figure 1 is a schematic representation of a magnetic bubble memory with a replicate port embodying this invention.

Figures 2 and 4 are enlarged top views of surface features of a portion of the memory of Figure 1, and

Figure 3 is a pulse diagram of the operation of the memory of Figure 1.

Detailed description

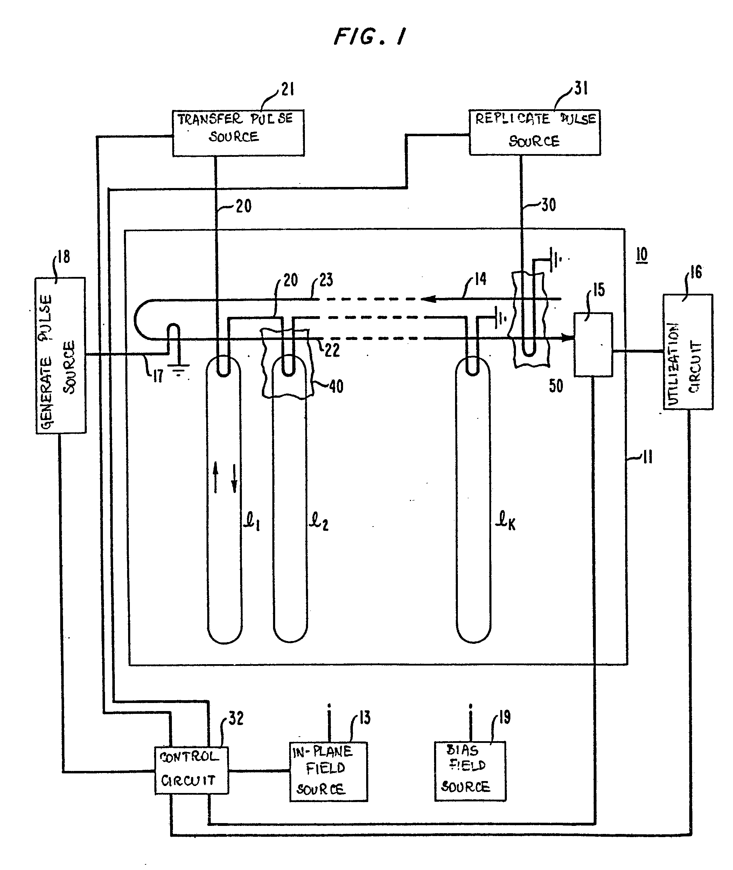

Figure 1 shows a magnetic bubble memory 10 including a layer 11 in which magnetic bubbles can be moved. Layer 11 includes a plurality of minor loops $l_1$, $l_2$- - -$l_k$ about which bubbles recirculate in response to an in-plane field reorienting in the plane of layer 11. The in-plane field is supplied by an in-plane field source represented by block 13. Layer 11 also includes major loop 14 to which a bubble detector and a bubble generator are coupled. A bubble detector is represented by block 15 and is operative responsive to the presence of a bubble to apply a signal indicative thereof to a utilization circuit represented by block 16. A bubble generator includes an electrical conductor 17 connected between a generate pulse source 18 and ground.

Bubbles are maintained at an operating diameter in layer 11 by a bias field supplied by source 19.

While the present invention is concerned with the replication of bubbles, a bubble "transfer" process is also described for greater understanding of the overall device.

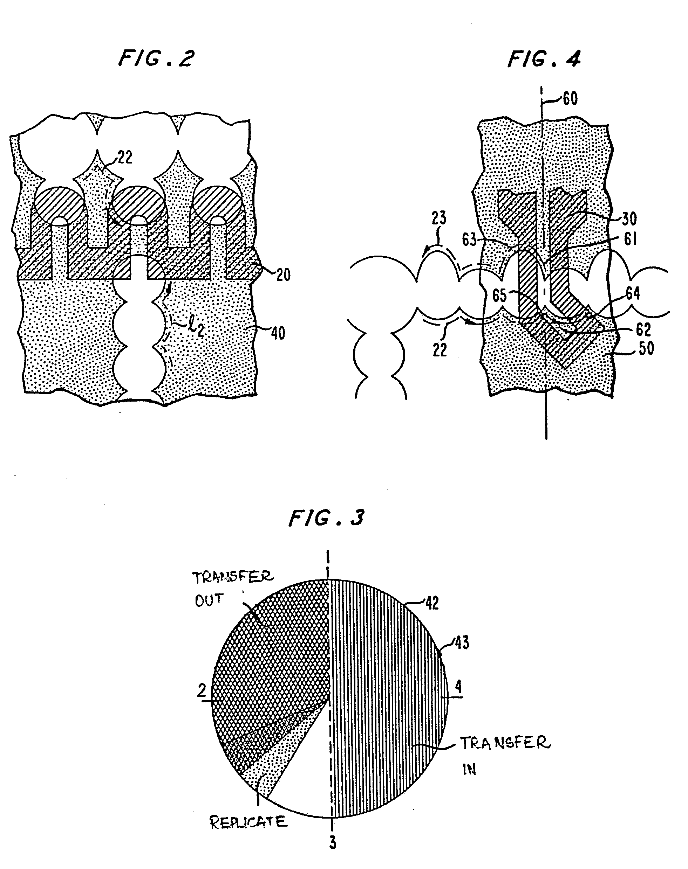

The major and minor loops, in the illustrative embodiment, are coupled by a transfer conductor 20 connected between a transfer pulse source 21 and ground. First and second legs 22 and 23 of major "loop" 14 are coupled together by a replicate conductor 30 connected between a replicate pulse source 31 and ground. Pulse sources 18, 21 and 31 and circuits 13, 15 and 16 herein are operative under the control of control circuit 32. In the illustrative embodiment, contiguous discs, defined by the absence of implanted ions in the otherwise implanted portions of layer 11, define bubble propagation paths through the layer. Figure 2 shows area 40 of Figure 1 enlarged to show the details of the transfer ports. The ion-implanted areas are shown stippled. Leg 22 of the major path 14 is shown as a broken arrow in Figure 2 as is minor loop $I_2$. Note that the paths of bubble movement follow the contour of the nonimplanted areas. The nonimplanted areas are shaped in the form of a series of connected circular or disc-shaped elements, the junctures of the discs forming inwardly facing "cusps", and the sides of the discs providing "bulges", the cusps and bulges alternating along the sides of the areas. Conductor 20 is defined by an electrical conductor pattern formed on top of layer 11 by well known techniques.

The transfer port is operative as a bidirectional port for transferring a bubble to or from a minor loop. That is to say, a bubble moving in the minor loop ($I_2$) can be transferred to path 22 by a pulse in conductor 20 when the in-plane field is in a *1* position and a bubble is at the top of the end nonimplanted disc of loop $I_2$. Figure 3 shows a diagram of the in-plane field with the 1, 2, 3 and 4 orientations (positions) for the in-plane field demonstrated on a circle 42. The field is moving in the counterclockwise direction as indicated by arrow head 43. The transfer-out pulse on conductor 20 is initiated when the field is in the *1* position and terminates before the field reaches the *3* position as indicated by the cross hatched region designated "transfer". Conversely, transfer of a bubble from path 22 to the minor loop $I_2$ occurs when a bubble reaches the nonimplanted disc opposite loop $I_2$ when the field is in the *3* position. A pulse on conductor 20 at that time, and terminating when the field next reorients to the *1* position, moves the bubble to path $I_2$. The broken line in Figure 3 indicates the limits of the transfer-in pulse.

Figure 4 shows an area 50 of Figure 1 enlarged. Legs 22 and 23 of loop 14 are shown in the figure along with conductor 30. It is clear from the discussion in connection with Figure 3 that bubbles in the minor loops are transferred to path 22 leaving vacancies in the minor loops and these transferred bubbles are later returned to those vacancies during a transfer-in operation. In order to implement such a return, the major path (14) is in a sense "closed" to form a return path for the bubbles by means of properly timed replicate pulses applied to conductor 30 by source 31 of Figure 1.

The replicate pulses are applied at times when a bubble is just leaving, for example, the cusp 65 (Figure 4) encompassed by the conductor 30 and is propagating towards the bulge 62. The bubble movement occurs in reponse to the in-plane field orienting towards the *3* position from the *2* position, as shown in Figure 3. In this orientation of the in-plane field, strong attractive magnetic poles are generated at positions corresponding to those designated (Figure 4) by numerals 62 (path 22) and 61 (path 23). The current pulse through the conductor 30 at this time generates a magnetic field which is effective to stretch the bubble propagating between positions 65 and 62 to a position extending between positions 61 and 62 and extending across position (cusp) 65. Because the field generated by the current pulse through the conductor 30 is precisely defined by the shape of the conductor, the stretched bubble is anchored firmly in place. The in-plane field generated poles at the positions 61 and 62 cooperate to achieve such anchoring.

The replicate pulse terminates before the in-plane field reorients to the *3* position as indicated by the stippled area of Figure 3. The in-plane field, when it reaches the *3* position, drives the encompassed cusp 65 of path 22 to a polarity to collapse bubbles, thereby severing the elongated bubble extending thereacross. Thus, the replicate field operates to stretch bubbles between two strong attractive poles whereas the propagate field provides the cutting field. Two bubbles result. The replicated bubble is now in leg 23 moving to the left, while the original bubble remains in leg 22 for movement to the right to the detection stage. The replicate bubble is later transferred back into the minor loop. The numbers of stages in the major loop and the minor loops are chosen to permit such a transfer.

The replicate function requires the movement of a bubble through a nonimplanted region. This action is rendered possible by a uniform ion-implanted layer usually occupying a surface region of layer 11. Such a uniformly implanted layer is in addition to the patterned implanted layer shown in Figures 1, 2 and 3.

The number of replicate pulses equals the number of minor loops so that all the data in a selected address, transferred out to path 22, during an address select operation, is replicated for return to the minor loops.

The geometry and position of the replicate conductor is important. The area encompassed by the hairpin extends over a nonimplanted layer and encompasses end positions (e.g. positions 62 and 61) in opposing legs (22 and 23) between which a bubble is stretched for eventual splitting, the two ends positions being poled to attract bubbles at a particular orientation of the in-plane field. In the illustrative embodiment, the end positions are chosen for a field oriented in the 3 position of Figure 3. Such positions are offset from one another because neither opposing bulges nor cusps are poled alike for any orientation of the in-plane field. Rather, like elements (e.g., cusps or bulges) of opposing paths are poled oppositely. Thus, with respect to an axis drawn through like elements of opposing legs, as axis 60 of Figure 4, end position 61 of leg 23 and end position 62 of path 22 are offset from each other. Because of this, the hairpin replicate conductor is designed, in the illustrative embodiment, to include a bent or offset portion in order that the conductor encompass the two like-poled positions in opposing paths.

In another embodiment, not illustrated, the two paths 22 and 23 are themselves offset from one another, the cusps of one path aligning with the bulges of the other. In such case a straight axis hairpin conductor encompass both end positions and an offset conductor portion is not necessary.

It is also important that conductor 20 extend in each direction beyond the opposing paths of bubble propagation. The reason for this is to provide a middle point in the strip to be affected by the collapsing pole when the in-plane field reorients appropriately. It has been found that when the conductor opening is not extended beyond the cusp in path 22, for example, the end of the strip is subjected to the collapsing field and the result is that the bubble may simply transfer to position 61.

The replicate conductor 30 herein is shown as having a hairpin geometry. But a single strand conductor can be made of operate similarly. Further, each of the transfer ports of Figures 1 and 2 may be replaced by the replicator of Figure 4 to achieve a major-minor organization operative without the replicator positioned as shown in Figure 1.

## Claims

1. A magnetic bubble memory comprising a layer (11) of material in which magnetic bubbles can be moved, said layer including a pattern of implanted ions defining first (22) and second (23) paths along which bubbles are movable in response to a reorienting magnetic field, a location (61, 62) on each of said paths exhibiting like magnetic polarity for said field oriented in a first direction, an electrical conductor (30) extending between said locations, means (31) for pulsing said conductor at a time when said field is in said first direction for generating a magnetic field for stretching a bubble disposed on one of said paths between said locations, characterized by means (65) responsive to said field when oriented in a second direction for severing said stretched bubble intermediate the ends thereof.

2. A magnetic bubble memory in accordance with claim 1, wherein said conductor (30) is hairpin in shape and encompasses said locations (61, 62).

3. A magnetic bubble memory in accordance with claim 2, wherein said locations (61, 62) are offset from one another, and said hairpin shaped conductor (30) has an offset shape to encompass said locations.

4. A magnetic bubble memory in accordance with any preceding claim, wherein in that said first and second paths are defined along opposing edges of a nonimplanted region in an ion-implanted layer, each of said edges comprising a pattern of alternating bulges and cusps.

5. A magnetic bubble memory in accordance with claim 4, wherein said conductor (30) extends beyond said first and second paths (22, 23) to encompass within the hairpin-shaped conductor (30) ion-implanted areas therebeyond.

6. A magnetic bubble memory in accordance with any preceding claim, wherein said bubble severing means (65) is disposed between said locations (61, 62) and along the direction of the stretched bubble.

7. A magnetic bubble memory in accordance with claim 6 wherein said bubble severing means (65) is defined by an interface between an ion-implanted and nonimplanted region of said layer.

## Patentansprüche

1. Magnetblasenspeicher mit

— einer Materialschicht (11), in der Magnetblasen bewegt werden können, wobei die Schicht ein Muster implantierter Ionen aufweist, das erste (22) und zweite (23) Wege, längs derer Blasen, ansprechend auf ein sich umorientierendes Magnetfeld, bewegbar sind, definieren,

— einem Ort (61, 62) an einem jeden der Wege, an dem gleiche magnetische Polarität für das in einer ersten Richtung orientierte Feld vorhanden ist,

— einem elektrischen Leiter (30), der sich zwischen diesen Orten erstreckt,

— einer Einrichtung (31) zum Pulsen des Leiters zu einem Zeitpunkt, wenn das Feld in der ersten Richtung orientiert ist, um ein Magnetfeld zum Dehnen einer auf einem der Wege zwischen jenen Orten befindlichen Blase zu erzeugen, gekennzeichnet durch
— eine Einrichtung (65), die auf das Feld, wenn dieses in einer zweiten Richtung orientiert ist, anspricht, um die gedehnte Blase zwischen deren Enden zu trennen.

2. Magnetblasenspeicher entsprechend Anspruch 1, wobei der Leiter (30) die Form einer Haarnadel hat und besagte Orte (61, 62) umgibt.

3. Magnetblasenspeicher entsprechend Anspruch 2, wobei besagte Orte (61, 62) gegeneinerander versetzt sind und der haarnadelförmige Leiter (30) eine versetzte Form besitzt, um besagte Orte zu umgeben.

4. Magnetblasenspeicher entsprechend einem der vorstehenden Ansprüche, wobei besagte erste und zweite Wege längs gegenüberliegenden Rändern einer nichtimplantierten Zone in einer ionenimplantierten Schicht definiert sind, wobei jede Kante ein Muster alternierender Spitzen und Ausbuchtungen aufweist.

5. Magnetblasenspeicher entsprechend Anspruch 4, wobei sich der Leiter (30) über die ersten und zweiten Wege (22, 23) erstreckt, um innerhalb des haarnadelförmigen Leiters (30) ionenimplantierte Gebiete hierüber zu umgeben.

6. Magnetblasenspeicher entsprechend einem der vorstehenden Ansprüche, wobei die Blasentrenneinrichtung (65) zwischen besagten Orten (61, 62) und längs der Richtung der gedehnten Blase angeordnet ist.

7. Magnetblasenspeicher entsprechend Anspruch 6, wobei die Blasentrenneinrichtung (65) definiert ist durch eine Grenzfläche zwischen einem ionenimplantierten und einem nichtimplantierten Bereich der Schicht.

## Revendications

1. Une mémoire à bulles magnétiques comprenant une couche (11) de matière dans laquelle on peut déplacer des bulles magnétiques, cette couche comprenant un motif d'ions implantés définissant des premier (22) et second (23) chemins le long desquels on peut déplacer des bulles sous l'effet d'un champ magnétique se réorientant, un emplacement (61, 62) sur chacun de ces chemins présentant une même polarité magnétique lorsque le champ est orienté dans une première direction, un conducteur électrique (30) s'étendant entre ces emplacements, des moyens (31) pour appliquer une impulsion au conducteur à un instant auquel le champ est dans la première direction, pour produire un champ magnétique destiné à étirer une bulle posée sur l'un des chemins entre les emplacements, caractérisée par des moyens (65) qui réagissent au champ lorsqu'il est orienté dans une seconde direction, en sectionnant la bulle étirée dans une position située entre ses extrémités.

2. Une mémoire à bulles magnétiques selon la revendication 1, dans laquelle le conducteur (30) a une forme en épingle à cheveux et entoure lesdits emplacements (61, 62).

3. Une mémoire à bulles magnétiques selon la revendication 2, dans laquelle lesdits emplacements (61, 62) sont mutuellement décalés, et le conducteur en forme d'épingle à cheveux (30) a une forme déviée pour entourer ces emplacements.

4. Une mémoire à bulles magnétiques selon l'une quelconque des revendications précédentes, dans laquelle les premier et second chemins sont définis le long de bords opposés d'une région non implantée dans une couche soumise à une implantation ionique, chacun de ces bords consistant en un motif formé par des renflements et des pointes alternés.

5. Une mémoire à bulles magnétiques selon la revendication 4, dans laquelle le conducteur (30) s'étend au-delà des premier et second chemins (22, 23) pour entourer dans le conducteur en forme d'épingle à cheveux (30) des zones soumises à implantation ionique qui sont situés au-delà de ces chemins.

6. Une mémoire à bulles magnétiques selon l'une quelconque des revendications précédentes, dans laquelle les moyens de sectionnement de bulles (65) sont placés entre lesdits emplacements (61, 62) et dans la direction de la bulle étirée.

7. Une mémoire à bulles magnétiques selon la revendication 6, dans laquelle les moyens de sectionnement de bulles (65) sont définis par une frontière entre une région soumise à implantation ionique et une région non implantée de ladite couche.

## FIG. 1

## FIG. 2

## FIG. 4

## FIG. 3

TRANSFER OUT

TRANSFER IN

REPLICATE